# EUROPEAN PATENT SPECIFICATION

(11) **EP 4 589 933 B1**
(45) Date of publication and mention of the grant of the patent: **30.09.2026**
(21) Application number: 23881428.9
(22) Date of filing: 25.08.2023
(51) Int. Cl.: H04M 1/02

(54) **ELECTRONIC DEVICE AND SIGNAL TRANSMISSION CONTROL METHOD**
ELEKTRONISCHE VORRICHTUNG UND SIGNALÜBERTRAGUNGSSTEUERUNGSVERFAHREN
DISPOSITIF ÉLECTRONIQUE ET PROCÉDÉ DE COMMANDE DE TRANSMISSION DE SIGNAL

(30) Priority: 28.10.2022 CN 202211332897
(43) Date of publication of application: 23.07.2025
(73) Proprietor: Honor Device Co., Ltd., Shenzhen, Guangdong 518040 (CN)
(72) Inventor: LI, Zhao, Shenzhen, Guangdong 518040 (CN); YUAN, Xiaolei, Shenzhen, Guangdong 518040 (CN)
(74) Representative: MERH-IP Matias Erny Reichl Hoffmann Patentanwälte PartG mbB
(86) International application number: PCT/CN2023/114968
(87) International publication number: WO 2024/087845

(56) References cited:
- WO-A1-2022/126467
- CN-A- 114 495 821
- CN-A- 115 003 020
- CN-U- 207 939 836
- CN-U- 217 240 720
- US-A1- 2022 057 910

## Description

### TECHNICAL FIELD

This application relates to the field of circuit technologies, and in particular, to an electronic device and a signal transmission control method.

### BACKGROUND

Currently, an electronic device, for example, a mobile phone, is generally provided with two printed circuit boards (Printed Circuit Boards, PCBs). To implement signal transmission between some functional devices arranged on the two PCBs, the two PCBs need to be connected through a flexible printed circuit (Flexible Printed Circuit, FPC). When the FPC is connected to the PCBs, a connector such as a board to board (board to board, BTB) connector usually needs to be used. In other words, an electrical signal is transmitted between the FPC and the PCBs through the BTB connector, thereby implementing signal transmission between the functional devices arranged on the two PCBs.

However, a larger quantity of BTB pins indicates poorer reliability, and the BTB is more prone to problems such as warping and falling off. Undoubtedly, reducing the quantity of BTB pins is a problem that needs to be urgently resolved.

CN217240720U discloses a flexible printed circuit board module that comprises functional components and a flexible printed circuit board. Therein, the functional components are mounted on the flexible printed circuit board and are electrically connected to the flexible printed circuit board.

### SUMMARY

To resolve the foregoing technical problem, this application provides an electronic device and a signal transmission control method. A quantity of BTB pins can be reduced.

In a first aspect, an embodiment of this application provides an electronic device. The electronic device includes a first printed circuit board and a second printed circuit board; a flexible printed circuit, a first connector, and a second connector, where one end of the flexible printed circuit is electrically connected to the first printed circuit board through the first connector, the other end of the flexible printed circuit is electrically connected to the second printed circuit board through the second connector, and the first connector and the second connector each include a first pin unit, a second pin unit, and a third pin unit; a control module, arranged on the first printed circuit board; at least two functional modules, arranged on the second printed circuit board, where the at least two functional modules include a first functional module and a second functional module, and both the first functional module and the second functional module are electrically connected to the control module through the first pin unit of the second connector, the flexible printed circuit, and the first pin unit of the first connector; a first power supply module, electrically connected to the first functional module through the second pin unit, and configured to supply power to the first functional module; a second power supply module, electrically connected to the second functional module through the third pin unit, and configured to supply power to the second functional module; a first switch module, located between the first power supply module and the first functional module; and a second switch module, located between the second power supply module and the second functional module, where when the first switch module is turned on, the control module is configured to implement signal interaction with the first functional module, and when the second switch module is turned on, the control module is configured to implement signal interaction with the second functional module.

A control module in an electronic device is arranged on a first printed circuit board, and at least two functional modules are arranged on a second printed circuit board. The at least two functional modules are electrically connected to the control module through a group of pin units sharing a connector. In addition, to avoid mutual impact between signals, a power supply module and a switch module electrically connected to the power supply module are arranged for each functional module, to implement signal transmission between the control module and each of the at least two functional modules in a time-sharing manner. In this way, compared with the related art in which each functional module is respectively electrically connected to the control module through the group of pin units of the connector, this solution can reduce a group of pin units, thereby reducing a quantity of pins in the connector, so that problems such as a large quantity of pins in the connector, poor reliability, and warping and falling off easily occurring in the connector are avoided.

For example, the at least two functional modules are arranged on the second printed circuit board. Signal receiving ends of the two functional modules may be arranged on the second printed circuit board, for example, may be arranged on the second printed circuit board through a connector (such as a BTB), or the functional modules may be arranged on the second printed circuit board. For example, signal ends of a display unit and a camera module are arranged on the second printed circuit board through the connector.

For example, the two functional modules are, for example, a first display unit and a second display unit in the embodiments, or may be a first I2C device and a second I2C device in the embodiments. Certainly, the functional module is not limited thereto, and any module that requires ID recognition and/or I2C signal transmission shall fall within the protection scope of this application. For example, the two functional modules may alternatively include a front-facing camera and/or a rear-facing camera. Certainly, signal interaction between the control module and the functional module is not limited to ID recognition and I2C signal transmission, and may further include interaction of other signals.

For example, the control module is, for example, an SOC that can perform ID recognition or I2C signal transmission. Certainly, the control module is not limited thereto.

For example, a quantity of functional modules is two, or may be three, four, or the like. Correspondingly, a quantity of switch modules and a quantity of power supply modules correspond to the quantity of functional modules, that is, are three, four, or the like. In this way, signal transmission between the control module and each of a plurality of functional modules may be implemented in a time-sharing manner, thereby reducing a quantity of BTB pins used.

For example, a quantity of pins in the first pin unit is two, a quantity of pins in the second pin unit is one, and a quantity of pins in the third pin unit is one. Alternatively, a quantity of pins in the first pin unit is three, a quantity of pins in the second pin unit is one, and a quantity of pins in the third pin unit is one. Certainly, the quantity of pins in the first pin unit, the quantity of pins in the second pin unit, and the quantity of pins in the third pin unit are not limited thereto, and all fall within the protection scope of embodiments of this application provided that a plurality of functional modules achieves an objective of reducing a quantity of pins by sharing a pin unit.

According to a first aspect, the electronic device includes a foldable terminal, where the foldable terminal includes a first body, a second body, and a rotating shaft structure connecting the first body and the second body; the first printed circuit board is arranged in the first body, and the second printed circuit board is arranged in the second body; and one end of the flexible printed circuit is electrically connected to the first printed circuit board through the first connector, and the other end of the flexible printed circuit passes through the rotating shaft structure and is electrically connected to the second printed circuit board through the second connector.

Such arrangement can avoid a problem of poor reliability caused by a large quantity of pins of a connector that passes through the flexible printed circuit and is electrically connected to the printed circuit board when the electronic device is the foldable terminal, and the foldable terminal is folded or unfolded back and forth.

According to the first aspect or any one of the foregoing implementations in the first aspect, the control module includes a power supply unit and an interface unit, where the power supply unit is respectively electrically connected to the first power supply module and the interface unit; and the power supply unit is configured to supply power to the interface unit based on a power supply signal provided by the first power supply module, to enable the control module to implement signal interaction with the first functional module or the second functional module through the interface unit. In other words, the first power supply module having a simple structure not only supplies power to the interface unit, to enable pins of the interface unit to work normally, but also supplies power to the functional module.

According to the first aspect or any one of the foregoing implementations in the first aspect, the electronic device further includes an isolation module, where one end of the isolation module, the first power supply module, and the first switch module are coupled to a first node, and the other end of the isolation module, the second power supply module, and the second switch module are coupled to a second node; and when both the first switch module and the second switch module are turned on, the isolation module is configured to block a signal at the first node from being transmitted to the second node, and block a signal at the second node from being transmitted to the first node. In such arrangement, backflow can be prevented between the power supply signal outputted by the first power supply module and the power supply signal outputted by the second power supply module.

According to the first aspect or any one of the foregoing implementations in the first aspect, the isolation module includes a first diode and a second diode, where an anode of the first diode is connected to the first node, a cathode of the first diode is electrically connected to a cathode of the second diode, and an anode of the second diode is electrically connected to the second node. In such arrangement, the isolation module has a simple structure and low costs.

According to the first aspect or any one of the foregoing implementations in the first aspect, the control module includes a system on chip, and when the first switch module is turned on, the control module is configured to recognize an identity of the first functional module through the interface unit, and when the second switch module is turned on, the control module is configured to recognize an identity of the second functional module through the interface unit. Certainly, the control module is not limited to the system on chip, and a person skilled in the art may select the control module according to an actual situation.

According to the first aspect or any one of the foregoing implementations in the first aspect, when the electronic device includes the foldable terminal, a first functional device includes an inner screen, and a second functional device includes an outer screen; and when the first switch module is turned on, the control module is configured to recognize an identity of the inner screen through the interface unit, and when the second switch module is turned on, the control module is configured to recognize an identity of the outer screen through the interface unit. When the control module performs recognition on the identities of the inner screen and the outer screen, there is no need to arrange a group of first pin units for each display unit, and mutual interference during recognition can also be avoided. A quantity of pin units is reduced to further reduce a quantity of BTB pins, so that problems such as a large quantity of BTB pins, poor reliability, and warping and falling off easily occurring in the BTB are avoided.

According to the first aspect or any one of the foregoing implementations in the first aspect, the control module includes a system on chip, a first functional device includes a first I2C device, and a second functional device includes a second I2C device, where the first I2C device includes a first serial data line interface and a first serial clock line interface, the second I2C device includes a second serial data line interface and a second serial clock line interface, and the interface unit includes a third serial data line interface and a third serial clock line interface; both the second serial data line interface and the third serial data line interface are electrically connected to the first serial data line interface, and both the second serial clock line interface and the third serial clock line interface are electrically connected to the first serial clock line interface; first pull-up resistors are respectively arranged between the first switch module and the first serial data line interface, and between the first switch module and the first serial clock line interface, and second pull-up resistors are respectively arranged between the second switch module and the second serial data line interface, and between the second switch module and the second serial clock line interface; and when the first switch module is turned on, the control module is configured to implement I2C signal interaction with the first I2C device; and when the second switch module is turned on, the control module is configured to implement I2C signal interaction with the second I2C device. When the control module performs I2C signal interaction with the first I2C device and the second I2C device, there is no need to arrange a group of first pin units for each I2C device, and mutual interference during recognition can also be avoided. A quantity of pin units is reduced to further reduce a quantity of BTB pins, so that problems such as a large quantity of BTB pins, poor reliability, and warping and falling off easily occurring in the BTB are avoided.

According to the first aspect or any one of the foregoing implementations in the first aspect, the first switch module includes a device such as a metal-oxide-semiconductor transistor or a triode that can implement a switch function; and the second switch module includes a device such as a metal-oxide-semiconductor transistor or a triode that can implement a switch function.

In a second aspect, an embodiment of this application provides a signal transmission control method, which is applied to the electronic device corresponding to the first aspect and any one of the foregoing implementations in the first aspect. The signal transmission control method includes: controlling the first switch module to be turned on, to enable the first switch module to supply power to the first functional module; performing signal interaction with the first functional module; controlling the first switch module to be turned off and controlling the second switch module to be turned on, to enable the second switch module to supply power to the second functional module; and performing signal interaction with the second functional module.

The second aspect and any one of the implementations in the second aspect correspond to the second aspect and any one of the implementations in the second aspect respectively. For the technical effects corresponding to the second aspect and any one of the implementations in the second aspect, refer to the technical effects corresponding to the foregoing first aspect and any one of the implementations in the first aspect. Details are not described herein again.

According to a second aspect, the controlling the first switch module to be turned on, to enable the first switch module to supply power to the first functional module includes: controlling the first switch module to be turned on; and sending a first control signal to the first functional module, to enable the first switch module to supply power to the first functional module; and the controlling the second switch module to be turned on, to supply power to the second functional module includes: controlling the second switch module to be turned on; and sending a second control signal to the second functional module, to enable the second switch module to supply power to the second functional module.

According to the second aspect or any one of the foregoing implementations in the second aspect, the performing signal interaction with the first functional module includes: obtaining an identification number of the first functional module; and the performing signal interaction with the second functional module includes: obtaining an identification number of the second functional module.

According to the second aspect or any one of the foregoing implementations in the second aspect, the performing signal interaction with the first functional module includes: performing I2C signal interaction with first functional module; and the performing signal interaction with the second functional module includes: performing I2C signal interaction with second functional module.

In a third aspect, an embodiment of this application provides a computer-readable storage medium. The computer-readable storage medium includes a computer program, and the computer program, when run on an electronic device, causes the electronic device to perform the signal transmission control method according to the second aspect and any one of the implementations in the second aspect.

The third aspect and any one of the implementations in the third aspect correspond to the second aspect and any one of the implementations in the second aspect respectively. For the technical effects corresponding to the third aspect and any one of the implementations in the third aspect, refer to the technical effects corresponding to the foregoing second aspect and any one of the implementations in the second aspect. Details are not described herein again.

According to a first example that is not encompassed by the claims but useful for understanding the invention, an embodiment of this application provides a computer program product, including a computer program. The computer program, when run, causes a computer to perform the signal transmission control method according to the second aspect or any one of the implementations in the second aspect.

The first example and any one of the implementations in the first example correspond to the second aspect and any one of the implementations in the second aspect respectively. For the technical effects corresponding to the first example and any one of the implementations in the first example, refer to the technical effects corresponding to the foregoing second aspect and any one of the implementations in the second aspect. Details are not described herein again.

According to a second example that is not encompassed by the claims but useful for understanding the invention, this application provides a chip, including a processing circuit, and a transceiver pin. The transceiver pin and the processing circuit communicate with each other through an internal connection path. The processing circuit performs the signal transmission control method according to the third aspect or any one of implementations in the third aspect, to control a receive pin to receive a signal, and to control a transmit pin to transmit the signal.

The second example and any one of the implementations in the second example correspond to the second aspect and any one of the implementations in the second aspect respectively. For the technical effects corresponding to the second example and any one of the implementations in the second example, refer to the technical effects corresponding to the foregoing second aspect and any one of the implementations in the second aspect. Details are not described herein again.

### BRIEF DESCRIPTION OF DRAWINGS

FIG. 1 is a schematic structural diagram of an electronic device according to an embodiment of this application;
FIG. 2 is a schematic structural diagram of another electronic device according to an embodiment of this application;
FIG. 3 is a cross-sectional view of FIG. 1 along a BB' direction;
FIG. 4 is a schematic structural diagram of a first body and a second body according to an embodiment of this application;
FIG. 5 is a cross-sectional view of FIG. 4 along a CC' direction;
FIG. 6 is a circuit diagram of an electronic device according to an embodiment of this application;
FIG. 7 is a circuit diagram of an electronic device in the related art;
FIG. 8 is a circuit diagram of another electronic device according to an embodiment of this application;
FIG. 9 is a circuit diagram of another electronic device according to an embodiment of this application;
FIG. 10 is a flowchart of a signal transmission control method according to an embodiment of this application; and
FIG. 11 is a flowchart of another signal transmission control method according to an embodiment of this application.

### DESCRIPTION OF EMBODIMENTS

The following clearly and completely describes the technical solutions in embodiments of this application with reference to the accompanying drawings in embodiments of this application. Apparently, the described embodiments are some rather than all of embodiments of this application. All other embodiments obtained by a person of ordinary skill in the art based on embodiments of this application without creative efforts shall fall within the protection scope of this application.

The term "and/or" used in this specification describes only an association relationship for describing associated objects and represents that three relationships may exist. For example, A and/or B may represent the following three cases: Only A exists, both A and B exist, and only B exists.

In the specification and claims in embodiments of this application, the terms such as "first" and "second" are intended to distinguish between different objects, but do not indicate a particular order of the objects. For example, a first target object and a second target object are intended to distinguish between different target objects, but do not indicate a specific order of the target objects.

In embodiments of this application, words such as "exemplary" or "for example" is used to represent giving an example, an illustration, or a description. Any embodiment or design solution described as an "exemplary" or "for example" in embodiments of this application should not be explained as being more preferred or having more advantages than another embodiment or design solution. To be precise, the use of the words such as "exemplary" or "for example" is intended to present a related concept in a specific manner.

In the descriptions of embodiments of this application, unless otherwise stated, "a plurality of" means two or more. For example, a plurality of processing units refer to two or more processing units; and a plurality of systems refer to two or more systems.

Embodiments of this application provide an electronic device and a signal transmission control method. A control module in the electronic device is arranged on a first PCB and at least two functional modules are arranged on a second PCB. The at least two functional modules are electrically connected to the control module through a group of pin units (which may include one pin, or may include a plurality of pins) of a BTB. In addition, to avoid mutual impact between signals, a power supply module and a switch module electrically connected to the power supply module are arranged for each functional module, to implement signal transmission between the control module and each of the at least two functional modules in a time-sharing manner. In this way, one group of pin units can be reduced, to further reduce a quantity of BTB pins, so that problems such as a large quantity of BTB pins, poor reliability, and warping and falling off easily occurring in the BTB are avoided.

The electronic device provided in embodiments of this application may be a terminal device such as a mobile phone, a tablet computer, a personal digital assistant (personal digital assistant, PDA for short), an in-vehicle computer, a television, a smart wearable device, and a smart home device. A specific form of the foregoing electronic device is not limited in embodiments of this application. The terminal device may be a straight type terminal or a foldable terminal. This is not limited in embodiments of this application.

A specific structure of an electronic device that reduces the quantity of BTB pins is described below by using an example in which the electronic device is a foldable terminal, and the foldable terminal is a foldable mobile phone.

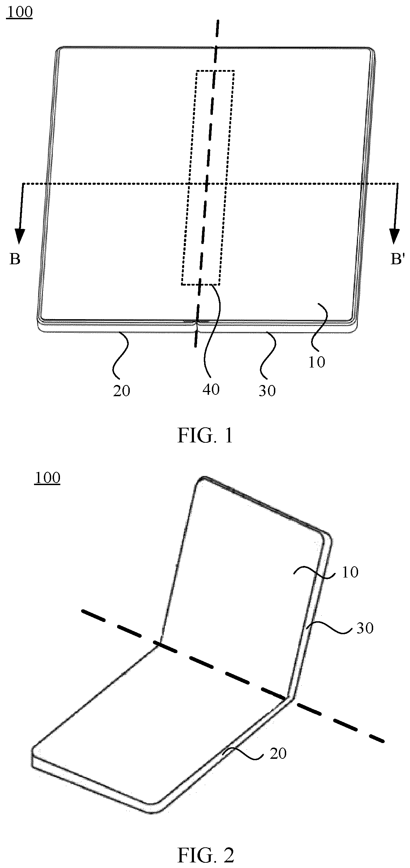

Referring to FIG. 1, a foldable mobile phone 100 includes a first display unit (which is also referred to as a foldable screen or a flexible screen) 10.

The first display unit 10 is, for example, a flexible display screen. The first display unit 10 includes, for example, an organic light emitting diode (Organic Light-Emitting Diode, OLED) display screen. The OLED display screen does not need to have a back light module, and a base substrate in the OLED display screen can be made of a flexible resin material, such as polyethylene terephthalate (polyethylene terephthalate, PET), so that the OLED display screen has a property of being bendable. Certainly, a type of the first display unit 10 includes, but is not limited to, the OLED display screen. A display screen that can be bent falls within the protection scope of this application. For example, the first display unit 10 may alternatively be a liquid crystal display (Liquid Crystal Display, LCD) screen or an LED display screen (including, for example, a Micro-LED display screen and a Mini-LED display screen).

Still referring to FIG. 1, the foldable mobile phone 100 further includes a structural assembly. The structural assembly includes a first body 20, a second body 30, and a rotating shaft structure 40 located between the first body 20 and the second body 30. The rotating shaft structure 40 is respectively connected to the first body 20 and the second body 30. The first body 20, the rotating shaft structure 40, and the second body 30 may be configured to carry the first display unit 10. The first body 20 and the second body 30 may respectively rotate around the rotating shaft structure 40, to implement a folded state, an unfolded state, or the like of the first display unit 10, that is, to implement the folded state, the unfolded state, or the like of the foldable mobile phone 100.

It is to be noted that, the foldable mobile phone 100 may be folded at a plurality of positions. Correspondingly, the structural assembly may include a plurality of rotating shaft structures 40 and a plurality of bodies. For example, the structural assembly may include two rotating shaft structures 40 and three bodies, and two adjacent bodies are connected to each other through one rotating shaft structure 40. In this way, the foldable mobile phone 100 has two folded positions. It can be learned that the structural assembly includes at least one rotating shaft structure 40 and at least two bodies, and two adjacent bodies are connected to each other through the rotating shaft structure 40. For ease of description, embodiments of this application are described by using an example in which the structural assembly includes one rotating shaft structure 40 and two bodies (that is, the first body 20 and the second body 30).

It is to be further noted that, FIG. 1 is described by using an example in which the foldable mobile phone 100 is folded in a longitudinal direction, that is, when the foldable mobile phone 100 is folded, left and right screens are formed, but the example does not constitute a limitation on this application. In another optional embodiment of this application, referring to FIG. 2, the foldable mobile phone 100 may alternatively be folded in a transverse direction, that is, when the foldable mobile phone 100 is folded, upper and lower screens are formed. The following content is described by using an example in which the foldable mobile phone 100 is folded in the longitudinal direction.

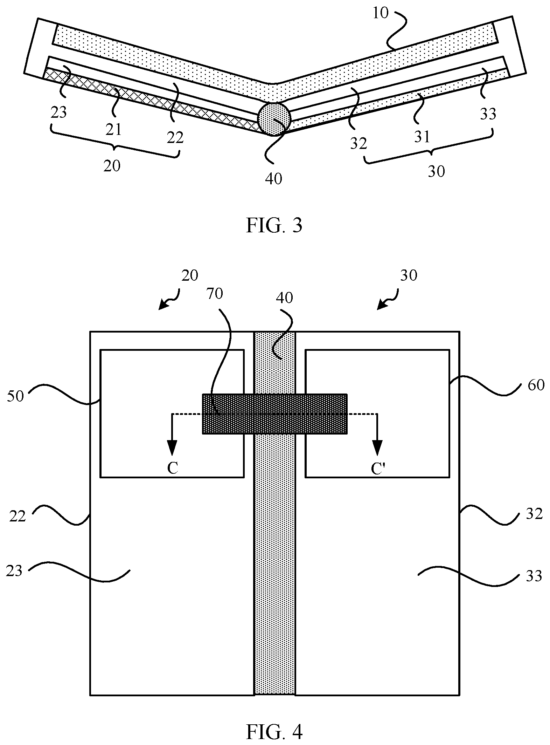

Referring to FIG. 3, the first body 20 includes a first housing 21 and a first middle frame 22. The flexible screen 10, the first housing 21, and the first middle frame 22 surround to form a first accommodating space 23. The second body 30 includes a second housing 31 and a second middle frame 32. The flexible screen 10, the second housing 31, and the second middle frame 32 surround to form a second accommodating space 33.

It is to be noted that, the first housing 21 may be a rear cover (which is also referred to as a battery cover) of the foldable mobile phone 100; or may be a display unit for display. This is not limited in embodiments of this application. The second housing 31 may be a rear cover (which is also referred to as a battery cover) of the foldable mobile phone; or may be a display unit for display. This is not limited in embodiments of this application. Embodiments of this application are described by using an example in which the first housing 21 is the rear cover and the second housing 31 is the display unit (which is also referred to as a second display unit, an outer screen, or a display screen, to distinguish from the foregoing first display unit 10).

A type of the second display unit 31 includes types of display screens such as an LCD display screen, an OLED display screen, and an LED display screen.

It is to be noted that, to more clearly present inventive points of this solution, FIG. 3 only shows structures related to the inventive points rather than all structures. It is similar in the accompanying drawings, and details are not described below again.

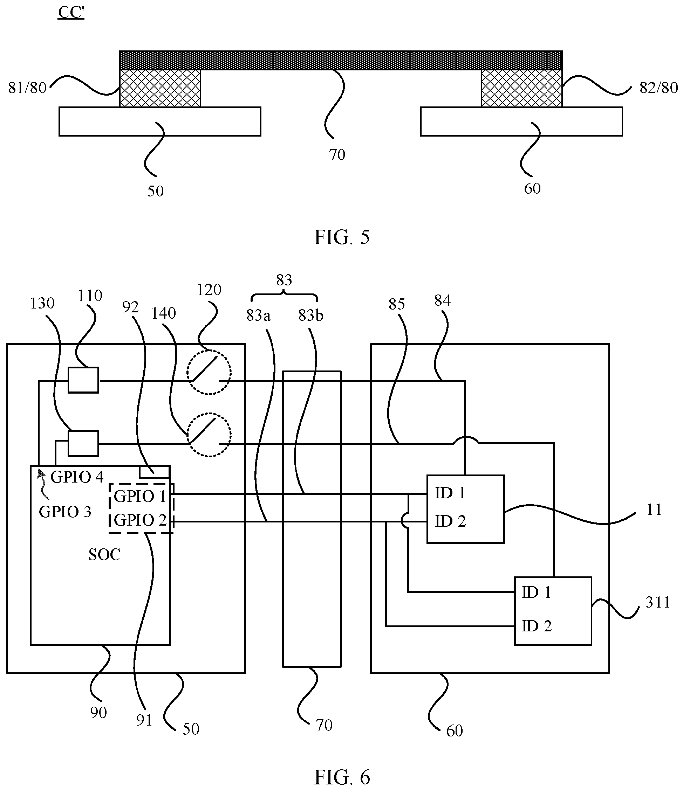

Referring to FIG. 4, the foldable mobile phone 100 further includes a first printed circuit board (Printed circuit board, PCB) 50, a second PCB 60, a through-shaft FPC 70, and the like, where one of the first PCB 50 and the second PCB 60 may be referred to as a main board, and the other may be referred to as a secondary board. The first PCB 50 is located in a first accommodating cavity 23, and the second PCB 60 is located in a second accommodating cavity 33. With reference to FIG. 5, one end of the through-shaft FPC 70 is electrically connected to the first PCB 50 through a connector 80 (that is, a first connector 81), and the other end of the through-shaft FPC 70 passes through the rotating shaft structure 40, and is electrically connected to the second PCB 60 through another connector 80 (that is, a second connector 82), so that the first PCB 50 and the second PCB 60 are electrically connected through the through-shaft FPC 70.

A type of the connector 80 is not limited in embodiments of this application, provided that the FPC 70 can be electrically connected to the first PCB 50 and the second PCB 60, thereby implementing signal transmission between the first PCB 50 and the second PCB 60. In some possible implementations, the connector 80 includes a BTB, that is, one BTB 80 is arranged between the first PCB 50 and the through-shaft FPC 70. The through-shaft FPC 70 is electrically connected to the first PCB 50 through the BTB 80. Another BTB 80 is arranged between the second PCB 60 and the through-shaft FPC 70. The same through-shaft FPC 70 is electrically connected to the second PCB 60 through the another BTB 80. Therefore, the first PCB 50 and the second PCB 60 are electrically connected through the through-shaft FPC 70. The following embodiments are also described by using an example in which the connector 80 is the BTB.

It is to be noted that, the first PCB 50 may be electrically connected to the second PCB 60 through one through-shaft FPC 70. Alternatively, the first PCB 50 may be electrically connected to the second PCB 60 through a plurality of (at least two) through-shaft FPCs 70. FIG. 4 is described by using only an example in which the first PCB 50 is electrically connected to the second PCB 60 through one through-shaft FPC 70.

It may be understood that the structure illustrated in embodiments of this application does not constitute a specific limitation on the foldable mobile phone. In other embodiments of this application, the foldable mobile phone may include more or fewer components than those shown in the figure, or some components may be combined, or some components may be combined, or positions of components are changed. The components shown in the figure may be implemented by hardware, software, or a combination of hardware and software.

To ensure functions such as communication and display of the foldable mobile phone 100, with reference to FIG. 6, the foldable mobile phone 100 further includes structures such as a system on chip (System on Chip, SOC) 90, a power management module (which is not shown in the figure), a front-facing camera (which is not shown in the figure), and a rear-facing camera (which is not shown in the figure). For example, the SOC 90 and the power management module are arranged on the first PCB 50. The SOC 90 may include one or more interfaces, and signal interaction between the SOC 90 and another structure is implemented through the interface. The interface may include a general-purpose input/output (General-Purpose Input/output, GPIO) interface, an inter-integrated circuit (Inter-Integrated Circuit, I2C) interface, a universal serial bus (Universal Serial Bus, USB) interface, and the like.

The first display unit 10 includes a first display part (that is, a part for displaying, which is not shown in FIG. 6) and a first signal end 11 (that is, a part for receiving a display signal and sending the display signal to the first display part, to enable the first display part to display). The second display unit 31 includes a second display part (that is, a part for displaying, which is not shown in FIG. 6) and a second signal end 311 (that is, a part for receiving a display signal and sending the display signal to the second display part, to enable the second display part to display). The first signal end 11 of the first display unit 10 is, for example, arranged on the second PCB 60 through one BTB (which is not shown in the figure). The first display unit 10 receives a display signal from a module such as the SOC 90 through the second PCB 60, the BTB, and the first signal end 11. The second signal end 311 of the second display unit 31 is, for example, arranged on the second PCB 60 through another BTB (which is not shown in the figure). The second display unit 31 receives a display signal from a module such as the SOC 90 through the second PCB 60, the BTB, and the second signal end 311.

The first connector 81 and the second connector 82 each include a first pin unit, where a quantity of pins in the first pin unit may be one or more. The first pin unit of the first connector 81 is electrically connected to the first pin unit of the second connector 82 through a wire 83 of the through-shaft FPC 70.

It is to be noted that, because a quantity of wires is in one-to-one correspondence with a quantity of pins in a pin unit, to simplify a circuit diagram, FIG. 6 only shows the wire 83 electrically connected to a BTB pin, and does not show the first pin unit.

To implement signal interaction between the SOC 90 and the first display unit 10 and between the SOC 90 and the second display unit 311, still referring to FIG. 6, the SOC 90 includes an interface unit 91, where the interface unit 91 includes at least one interface. The interface unit 91 of the SOC 90 is electrically connected to the first signal end 11 through the first pin unit of the first connector 81, the wire 83, the first pin unit of the second connector 82, and the BTB of the first signal end 11, thereby implementing an electrical connection between the SOC 90 and the first display unit 10. In addition, the interface unit 91 of the SOC 90 is electrically connected to the second signal end 311 through the first pin unit of the first connector 81, the wire 83, the first pin unit of the second connector 82, and the BTB of the second signal end 311, thereby implementing an electrical connection between the SOC 90 and the second display unit 31. In other words, both the first display unit 10 and the second display unit 31 are electrically connected to the interface unit 91 of the SOC 90.

It may be understood that a quantity of interfaces in the interface unit 91 is the same as the quantity of pins in the first pin unit, and the interfaces and the pins are electrically connected in one-to-one correspondence.

To avoid mutual impact between signals, still referring to FIG. 6, the first connector 81 and the second connector 82 each further include a second pin unit and a third pin unit, where a quantity of pins in the second pin unit and a quantity of pins in the third pin unit may be one or more. The second pin unit of the first connector 81 is electrically connected to the second pin unit of the second connector 82 through a wire 84 of the through-shaft FPC 70, and the third pin unit of the first connector 81 is electrically connected to the third pin unit of the second connector 82 through the wire 84 of the through-shaft FPC 70.

It is to be noted that, because a quantity of wires is in one-to-one correspondence with a quantity of pins in a pin unit, to simplify a circuit diagram, FIG. 6 only shows the wire 84 and a wire 85 that are electrically connected to BTB pins, and does not show the second pin unit and the third pin unit.

The foldable mobile phone 100 further includes a first power supply module 110. The first power supply module 110 is electrically connected to the first signal end 11 through the second pin unit of the first connector 81, the wire 84, and the second pin unit of the second connector 82, to supply power to the first display unit 10, thereby ensuring normal working of the first display unit 10. For example, the SOC 90 is electrically connected to the first power supply module 110 through a GPIO 3 interface, to control whether the first power supply module 110 works. In addition, a first switch module 120 is arranged between the first power supply module 110 and the first signal end 11. Specifically, a first end of the first switch module 120 is electrically connected to the first power supply module 110, a second end of the first switch module 120 is electrically connected to the second pin unit of the first connector 81, and a control end of the first switch module 120 is electrically connected to the SOC 90. The SOC 90 controls the first switch module 120 to be turned on or turned off. When the first switch module 120 is controlled to be turned on and the first power supply module 110 is enabled, the first power supply module 110 supplies power to the first display unit 10 through the second pin unit of the first connector 81, the wire 84, and the second pin unit of the second connector 82, thereby ensuring normal working of the first display unit 10.

The SOC 90 further includes a power supply unit 92 electrically connected to the first power supply module 110. The power supply unit 92 receives a power supply signal of the first power supply module 110 and supplies power to interfaces of the SOC 90, to ensure normal working of the interfaces.

The foldable mobile phone 100 further includes a second power supply module 130. The second power supply module 130 is electrically connected to the second signal end 311 through the third pin unit of the first connector 81, the wire 85, and the third pin unit of the second connector 82, to supply power to the second display unit 31, thereby ensuring normal working of the second display unit 31. For example, the SOC 90 is electrically connected to the second power supply module 130 through a GPIO 4 interface, to control whether the second power supply module 130 works. In addition, a second switch module 140 is arranged between the second power supply module 130 and the second signal end 311. Specifically, a first end of the second switch module 140 is electrically connected to the second power supply module 130, a second end of the second switch module 140 is electrically connected to the third pin unit of the first connector 81, and a control end of the second switch module 130 is electrically connected to the SOC 90. The SOC 90 controls the second switch module 140 to be turned on or turned off. When the second switch module 140 is controlled to be turned on and the second power supply module 130 is enabled, the second power supply module 130 supplies power to the second display unit 31 through the third pin unit of the first connector 81, the wire 85, and the third pin unit of the second connector 82, thereby ensuring normal working of the second display unit 31.

In other words, in this embodiment of this application, a power supply module and a switch module electrically connected to the power supply module are arranged for each of the first display unit 10 and the second display unit 31. When the SOC 90 controls the first switch module 120 to be turned on and enables the first power supply module 110, the first power supply module 110 supplies power to the first display unit 10, and the first display unit 10 works normally. In this case, because the second switch module 140 is not turned on, and the second display unit 31 does not work, the SOC 90 may perform signal interaction with the first display unit 10 through the first pin unit of the first connector, the wire 83, and the first pin unit of the second connector. When the SOC 90 controls the second switch module 140 to be turned on and enables the second power supply module 130, the second power supply module 130 supplies power to the second display unit 31, and the second display unit 31 works normally. In this case, because the first switch module 120 is not turned on, and the first display unit 10 does not work, the SOC 90 may perform signal interaction with the second display unit 31 through the first pin unit of the first connector, the wire 83, and the first pin unit of the second connector, that is, implement interaction and transmission of signals between the SOC 90 and the first display unit 10 and between the SOC 90 and the second display unit 31 in a time-sharing manner. In this way, only one group of first pin units may be arranged. In comparison with arranging one group of first pin units for each display unit, a quantity of pin units is reduced to further reduce a quantity of BTB pins, so that problems such as a large quantity of BTB pins, poor reliability, and warping and falling off easily occurring in the BTB are avoided.

The beneficial effects are described below by comparing with the related art.

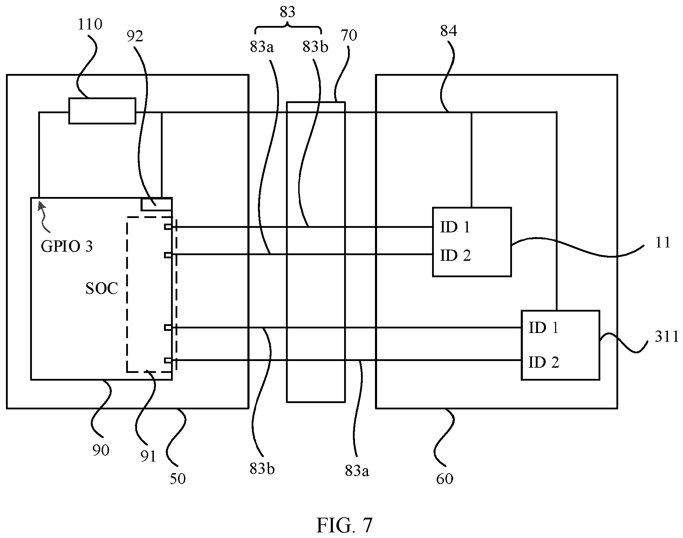

Referring to FIG. 7, the foldable mobile phone 100 in the related art includes the first power supply module 110. The first power supply module 110 is respectively electrically connected to the first signal end 11 and the second signal end 311 through the second pin unit of the first connector 81, the wire 84, and the second pin unit of the second connector 82, to simultaneously supply power to the first display unit 10 and the second display unit 31, thereby ensuring normal working of the first display unit 10 and the second display unit 31. To avoid mutual impact between signals transmitted by the first display unit 10 and the second display unit 31, the interface unit 91 of the SOC 90 is electrically connected to the first signal end 11 through the first pin unit of the first connector 81, the wire 83, the first pin unit of the second connector 82, and the BTB of the first signal end 11, thereby implementing an electrical connection between the SOC 90 and the first display unit 10. In addition, the interface unit 91 of the SOC 90 is electrically connected to the second signal end 311 through the third pin unit of the first connector 81, the wire 83, the third pin unit of the second connector 82, and the BTB of the second signal end 311, thereby implementing an electrical connection between the SOC 90 and the second display unit 31. In other words, the first display unit 10 and the second display unit 31 are respectively electrically connected to different pin units in the interface unit 91 of the SOC 90. A quantity of pins in the first pin unit for supplying power to the first display unit 11 and the second display unit 31 is generally one, a quantity of pins in the second pin unit for implementing signal interaction between the SOC 90 and the first display unit 10 is generally two, and a quantity of pins in the third pin unit for implementing signal interaction between the SOC 90 and the second display unit 31 is generally two. In other words, in the related art, to avoid mutual impact between the first display unit 10 and the second display unit 31 during signal transmission, at least five pins in the BTB are required. However, in embodiments of this application, when the first display unit 11 and the second display unit 31 are powered, an extra group of pin units is provided, but a quantity of extra group of pin units is one. However, the first display unit 10 and the second display unit 31 share a group of pin units (that is, the first pin unit) when transmitting signals. Therefore, when signal transmission is implemented, a group of pin units may be reduced, and a quantity of pins in the reduced group of pin units is two. In other words, in the related art, to avoid mutual impact between signals transmitted by the first display unit 10 and the second display unit 31, a quantity of BTB pins used is generally five. In embodiments of this application, to avoid mutual impact between signals transmitted by the first display unit 10 and the second display unit 31, the quantity of BTB pins used is generally four. It can be seen that, at least one pin in the BTB is reduced by using the solution of embodiments of this application. A person skilled in the art may learn that, a quantity of pins in different BTB is not gradually increased. For example, an existing BTB generally includes a 24-pin BTB, a 32-pin BTB, a 40-pin BTB, a 60-pin BTB, and an 80-pin BTB. Therefore, when one more pin is provided, a BTB with a quantity of pins may be changed to a BTB with a larger quantity of pins, for example, the 60-pin BTB is changed to the 80-pin BTB. In other words, for an item with scarce BTB resources, insufficient resources may cause expansion of a quantity of BTB pins, finally causing reliability risks of the item. The arrangement in embodiments of this application can reduce a quantity of at least one pin in the BTB, thereby avoiding problems such as a large quantity of BTB pins, poor reliability, and warping and falling out easily occurring in the BTB.

The foregoing effect is described below with reference to application scenarios.

In a scenario, that is, a scenario in which the SOC 90 recognizes identities (Identities, IDs) of the first display unit 10 and the second display unit 31 through the interface unit 91, still referring to FIG. 6, the interface unit 91 includes two GPIO interfaces (GPIO 1 and GPIO 2). Correspondingly, the first pin unit of the first connector 81 and the first pin unit of the second connector 82 each include the first pin and the second pin, the wire 83 of the FPC 70 includes a first wire 83a and a second wire 83b, and the first signal end 11 of the first display unit 10 and the second signal end 311 of the second display unit 31 each include a first identity port ID 1 and a second identity port ID 2. The GPIO 1 interface of the SOC 90 is respectively electrically connected to the first identity port ID 1 of the first signal end 11 and the first identity port ID 1 of the second signal end 311 through the first pin of the first connector 81, the first wire 83a, and the first pin of the second connector 82. The GPIO 2 interface of the SOC 90 is electrically connected to the second identity port ID 2 of the first signal end 11 and the second identity port ID 2 of the second signal end 311 through the second pin of the first connector 81, the second wire 83b, and the second pin of the second connector 82.

Specifically, when the SOC 90 controls the first switch module 120 to be turned on, and enables the first power supply module 110 through the GPIO 3 interface, the first power supply module 110 supplies power to the first display unit 10 through the first switch module 120, and the first display unit 10 works normally. In this case, because the second switch module 140 is not turned on, and the second display unit 31 does not work, the SOC 90 may read a first identity at the first identity port ID 1 of the first signal end 11 through the GPIO 1 interface, the first pin of the first connector 81, the first wire 83a, and the first pin of the second connector 82, and read a second identity at the second identity port ID 2 of the first signal end 11 through the GPIO 2 interface, the second pin of the first connector 81, the second wire 83b, and the second pin of the second connector 82. The first identity and the second identity are IDs of the first display unit 10. Then, the SOC 90 may load software in a version corresponding to the ID based on the ID of the first display unit 10.

When the SOC 90 controls the second switch module 140 to be turned on, and enables the second power supply module 130 through the GPIO 4 interface, the second power supply module 130 supplies power to the second display unit 31 through the second switch module 140, and the second display unit 31 works normally. In this case, because the first switch module 120 is not turned on, and the first display unit 10 does not work, the SOC 90 may read a first identity at the first identity port ID 1 of the second signal end 311 through the GPIO 1 interface, the first pin of the first connector 81, the first wire 83a, and the first pin of the second connector 82, and read a second identity at the second identity port ID 2 of the second signal end 311 through the GPIO 2 interface, the second pin of the first connector 81, the second wire 83b, and the second pin of the second connector 82. The first identity and the second identity are IDs of the second display unit 31. Then, the SOC 90 may load software in a version corresponding to the ID based on the ID of the second display unit 31.

In other words, the SOC 90 obtains the ID of the first display unit 10 and the ID of the second display unit 31 in a time-sharing manner. In this way, when the ID of the first display unit 10 and the ID of the second display unit 31 are recognized, only two pins (the first pin and the second pin) are required, and there is no need to arrange a corresponding first pin and second pin for each display unit. Although, when the first display unit 11 and the second display unit 31 are powered, an extra group of pin units is provided, but a quantity of extra group of pin units is one. Therefore, at least one pin can be reduced, to avoid problems such as a large quantity of BTB pins, poor reliability, and warping and falling off easily occurring in the BTB.

It is to be noted that, the foregoing ID of the first display unit 10 and ID of the second display unit 31 are determined by two identities, but do not constitute a limitation on this application. The foregoing ID of the first display unit 10 and ID of the second display unit 31 may alternatively be determined by three identities, four identification numbers, or the like. Correspondingly, a quantity of GPIO interfaces in the interface unit 91, a quantity of pins in the first pin unit of the first connector 81, a quantity of pins in the first pin unit of the second connector 82, a quantity of wires 83 of the FPC 70, a quantity of identities in the first signal end 11 of the first display unit 10, and a quantity of identities in the second signal end 311 of the second display unit 31 also correspondingly change. However, it is the same that, through this solution, at least one BTB pin can be reduced.

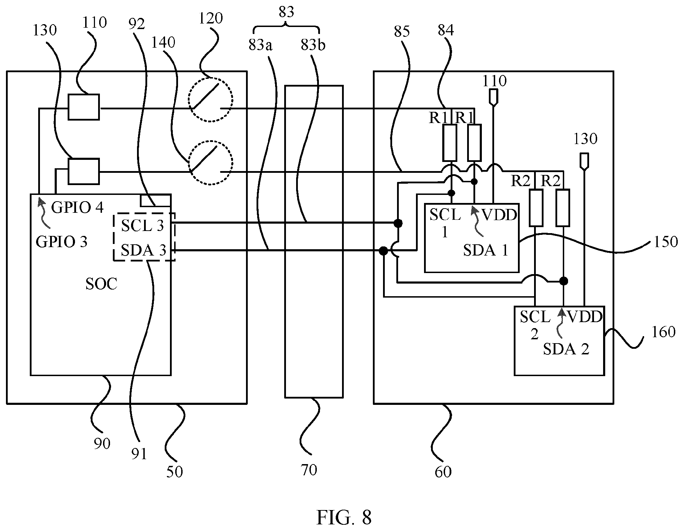

In another scenario, that is, a scenario in which the SOC 90 communicates with a first I2C device 150 and a second I2C device 160 through an I2C bus. The first I2C device 150 includes, for example, a device that can communicate with the SOC 90 through the I2C bus, such as a front-facing camera or a rear-facing camera, and the second I2C device 160 includes, for example, a device that can communicate with the SOC 90 through the I2C bus, such as a rear-facing camera or a front-facing camera. It is to be understood that, the I2C bus is a bidirectional two-wire synchronous serial bus, namely a serial data line (serial data line, SDA) and a serial clock line (serial clock line, SCL). The serial data line is used for transmitting a data signal, and the serial clock line is used for transmitting a clock signal. Referring to FIG. 8, correspondingly, the first I2C device 150 includes a first serial data line interface SCL 1 and a first serial clock line interface SDA 1. The second I2C device 160 includes a second serial data line interface SCL 2 and a second serial clock line interface SDA 2. The interface unit 91 includes a third serial data line interface SCL 3 and a third serial clock line interface SDA 3. The serial data line interface and the serial clock line interface are collectively referred to as I2C interfaces. Both the second serial data line interface SCL 2 and the first serial data line interface SCL 1 are electrically connected to the third serial data line interface SCL 3, and both the second serial clock line interface SDA 2 and the first serial clock line interface SDA 1 are electrically connected to the third serial clock line interface SDA 3. First pull-up resistors R1 are respectively arranged between the first switch module 120 and the first serial data line interface SCL 1, and between the first switch module 120 and the first serial clock line interface SDA 1, so that the first serial data line interface SCL 1 and the first serial clock line interface SDA 1 are electrically connected to the first power supply module 110 through the first pull-up resistors R1, thereby ensuring normal working of the first serial data line interface SCL 1 and the first serial clock line interface SDA 1. Second pull-up resistors R2 are respectively arranged between the second switch module 140 and the second serial data line interface SCL 2, and between the second switch module 140 and the second serial clock line interface SDA 2, so that the second serial data line interface SCL 2 and the second serial clock line interface SDA 2 are electrically connected to the second power supply module 130 through the second pull-up resistors R2, thereby ensuring normal working of the second serial data line interface SCL 2 and the second serial clock line interface SDA 2. Correspondingly, the first pin unit of the first connector 81 and the first pin unit of the second connector 82 each include the first pin and the second pin, and the wire 83 of the FPC 70 includes the first wire 83a and the second wire 83b. The third serial data line interface SCL 3 of the SOC 90 is respectively electrically connected to the first serial data line interface SCL 1 of the first I2C device 150 and the second serial data line interface SCL 2 of the second I2C device 160 through the first pin of the first connector 81, the first wire 83a, and the first pin of the second connector 82. The third serial clock line interface SDA 3 of the SOC 90 is electrically connected to the first serial clock line interface SDA 1 of the first I2C device 150 and the second serial clock line interface SDA 2 of the second I2C device 160 through the second pin of the first connector 81, the second wire 83b, and the second pin of the second connector 82. In addition, to ensure normal working of the first I2C device 150 and the second I2C device 160, the first I2C device 150 and the second I2C device 160 each include a power supply terminal VDD, the power supply terminal VDD of the first I2C device 150 is electrically connected to the first power supply module 110, and the power supply terminal VDD of the second I2C device 160 is electrically connected to the second power supply module 130.

Specifically, when the SOC 90 controls the first switch module 120 to be turned on, and enables the first power supply module 110 through the GPIO 3 interface, the first power supply module 110 supplies power to the first serial data line interface SCL 1 and the first serial clock line interface SDA 1 through the first switch module 120 and the first pull-up resistor R1, and the first serial data line interface SCL 1 and the first serial clock line interface SDA 1 work normally. In this case, because the second switch module 140 is not turned on, and the second serial data line interface SCL 2 and the second serial clock line interface SDA 2 do not work, the SOC 90 may be electrically connected to the first serial data line interface SCL 1 through the third serial data line interface SCL 3, the first pin of the first connector 81, the first wire 83a, and the first pin of the second connector 82, and may be electrically connected to the first serial clock line interface SDA 1 through the third serial clock line interface SDA 3, the second pin of the first connector 81, the second wire 83b. the second pin of the second connector 82, so that the SOC 90 and the first I2C device 150 can implement I2C signal interaction.

When the SOC 90 controls the second switch module 140 to be turned on, and enables the second power supply module 130 through the GPIO 4 interface, the second power supply module 130 supplies power to the second serial data line interface SCL 2 and the second serial clock line interface SDA 2 through the second switch module 140 and the second pull-up resistor R2, and the second serial data line interface SCL 2 and the second serial clock line interface SDA 2 work normally. In this case, because the first switch module 120 is not turned on, and the first serial data line interface SCL 1 and the first serial clock line interface SDA 1 do not work, the SOC 90 may be electrically connected to the second serial data line interface SCL 2 through the third serial data line interface SCL 3, the first pin of the first connector 81, the first wire 83a, and the first pin of the second connector 82, and may be electrically connected to the second serial clock line interface SDA 2 through the third serial clock line interface SDA 3, the second pin of the first connector 81, the second wire 83b, and the second pin of the second connector 82. Then, the SOC 90 and the second I2C device 160 are enabled to implement I2C signal interaction.

In other words, the SOC 90 may perform I2C signal interaction with the first I2C device 150 and the second I2C device 160 in a time-sharing manner. In this way, during I2C signal interaction, only two pins (the first pin and the second pin) are required in the first connector 81 and the second connector 82, and there is no need to arrange a corresponding first pin and second pin for each I2C device. Although, when the first display unit 11 and the second display unit 31 are powered, an extra group of pin units is provided, but a quantity of extra group of pin units is one. Therefore, at least one pin can be reduced, to avoid problems such as a large quantity of BTB pins, poor reliability, and warping and falling off easily occurring in the BTB.

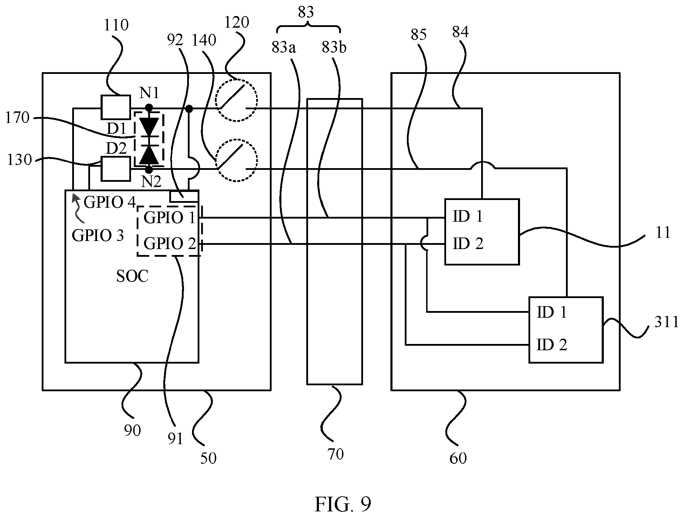

In the foregoing two scenarios, backflow is prevented between the power supply signal outputted by the first power supply module 110 and the power supply signal outputted by the second power supply module 130. Referring to FIG. 9, the foldable terminal 100 further includes an isolation module 170. One end of the isolation module 170, the first power supply module 110, and the first switch module 120 are coupled to a first node N1, and the other end of the isolation module 170, the second power supply module 130, and the second switch module 140 are coupled to a second node N2. When both the first switch module 110 and the second switch module 130 are turned on, the isolation module 170 is configured to block a signal at the first node N1 from being transmitted to the second node N2, and block a signal at the second node N2 from being transmitted to the first node N2.

For a specific structure of the isolation module 170, the specific structure of the isolation module 170 is not limited in embodiments of this application, provided that the signal at the first node N1 can be prevented from being transmitted to the second node N2, and the signal at the second node N2 can be prevented from being transmitted to the first node N1.

In some possible implementations, still referring to FIG. 9, the isolation module 170 includes a first diode D1 and a second diode D2. An anode of the first diode D1 is connected to the first node N1, a cathode of the first diode D2 is electrically connected to a cathode of the second diode D2, and an anode of the second diode D2 is electrically connected to the second node N2.

It is to be noted that, FIG. 8 is described by using an example in which the isolation module 170 is arranged in a scenario in which the SOC 90 recognizes the IDs of the first display unit 10 and the second display unit 311 through the interface unit 91, and does not constitute a limitation on this application. A scenario in which the SOC 90 communicates with the first I2C device 150 and the second I2C device 160 through the I2C bus is also applicable.

For types of the first switch module 120 and the second switch module 140, the types of the first switch module 120 and the second switch module 140 are not limited in embodiments of this application, provided that the first switch module 120 and the second switch module 140 can implement a switch function. For example, the first switch module 120 includes a metal-oxide-semiconductor transistor or a triode, and the second switch module 140 includes a metal-oxide-semiconductor transistor or a triode.

An embodiment of this application further provides a signal transmission control method. The signal transmission control method, for example, may be applied to the foldable terminal in this embodiment, and has the same beneficial effects. For details that are not elaborated in this embodiment, refer to the foregoing embodiments of the foldable terminal. The signal transmission control method is described below with reference to the foldable terminal shown in FIG. 8.

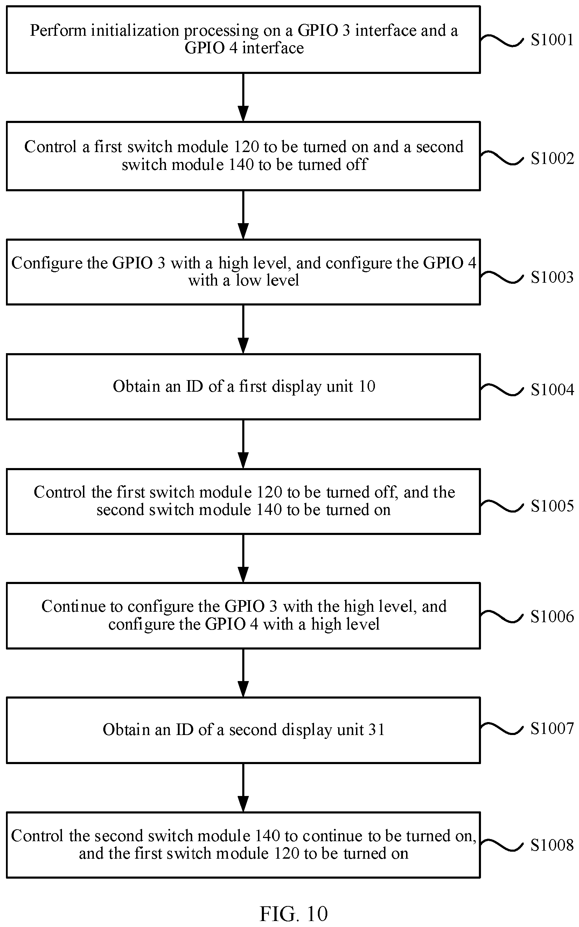

As shown in FIG. 10, the signal transmission control method can be implemented through the following steps.

S1001: Perform initialization processing on a GPIO 3 interface and a GPIO 4 interface.

An SOC 90 performs initialization processing on the GPIO 3 interface and the GPIO 4 interface, to prevent impact of another signal.

S1002: Control a first switch module 120 to be turned on and a second switch module 140 to be turned off.

The SOC 90 controls the first switch module 120 to be turned on, and controls the second switch module 140 to be turned off.

S1003: Configure the GPIO 3 with a high level, and configure the GPIO 4 with a low level.

A first power supply module 110 starts to work based on the high level at the GPIO 3, to supply power to a first display unit 10, thereby ensuring normal working of the first display unit 10. The second power supply module 130 does not work based on the low level at the GPIO 4.

S1004: Obtain an ID of the first display unit 10.

When the SOC 90 controls the first switch module 120 to be turned on, and enables the first power supply module 110 through the GPIO 3 interface, the first power supply module 110 supplies power to the first display unit 10 through the first switch module 120, and the first display unit 10 works normally. In this case, because the second switch module 140 is not turned on, and a second display unit 31 does not work, the SOC 90 may read a first identity at a first identity port ID 1 of a first signal end 11 through a GPIO 1 interface, a first pin of a first connector 81, a first wire 83a, and a first pin of a second connector 82, and read a second identity at a second identity port ID 2 of the first signal end 11 through a GPIO 2 interface, a second pin of the first connector 81, a second wire 83b, and a second pin of the second connector 82. The first identity and the second identity are IDs of the first display unit 10. In this way, the SOC 90 may load, based on the ID of the first display unit 10 of the SOC 90, software in a version corresponding to the ID.

S1005: Control the first switch module 120 to be turned off, and the second switch module 140 to be turned on.

The SOC 90 controls the first switch module 120 to be turned off, and controls the second switch module 140 to be turned on.

S1006: Continue to configure the GPIO 3 with the high level, and continue to configure the GPIO 4 with a high level.

The first power supply module 110 starts to work based on the high level at the GPIO 3, to supply power to a power supply unit 92, to ensure normal working of interfaces of the SOC 90. The second power supply module 130 starts to work based on the high level at the GPIO 4, to supply power to the second display unit 31, thereby ensuring normal working of the second display unit 31.

S1007: Obtain an ID of a second display unit 31.

When the SOC 90 controls the second switch module 140 to be turned on, and enables the second power supply module 130 through the GPIO 4 interface, the second power supply module 130 supplies power to the second display unit 31 through the second switch module 140, and the second display unit 31 works normally. In this case, because the first switch module 120 is not turned on, and the first display unit 10 does not work, the SOC 90 may read a first identity at a first identity port ID 1 of a second signal end 311 through the GPIO 1 interface, the first pin of the first connector, the first wire 83a, and the first pin of the second connector, and read a second identity at a second identity port ID 2 of the second signal end 311 through the GPIO 2 interface, the second pin of the first connector, the second wire 83b, and the second pin of the second connector. The first identity and the second identity are IDs of the second display unit 31. In this way, the SOC 90 may load, based on the ID of the second display unit 31, software in a version corresponding to the ID.

S1008: Control the second switch module 140 to continue to be turned on, and the first switch module 120 to be turned on.

In this way, normal working of the first display unit 10 and the second display unit 31 can be ensured.

An embodiment of this application further provides a signal transmission control method. The signal transmission control method, for example, may be applied to the foldable terminal in this embodiment, and has the same beneficial effects. For details that are not elaborated in this embodiment, refer to the foregoing embodiments of the foldable terminal. The signal transmission control method is described below with reference to the foldable terminal shown in FIG. 8.

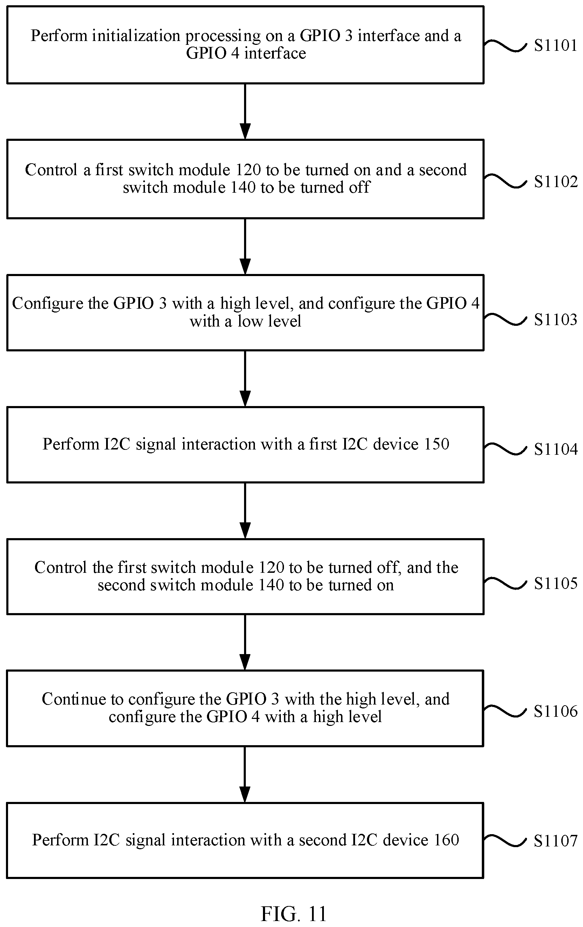

As shown in FIG. 11, the signal transmission control method can be implemented through the following steps:
S1101: Perform initialization processing on a GPIO 3 interface and a GPIO 4 interface.

An SOC 90 performs initialization processing on the GPIO 3 interface and the GPIO 4 interface, to prevent impact of another signal.

S1102: Control a first switch module 120 to be turned on and a second switch module 140 to be turned off.

The SOC 90 controls the first switch module 120 to be turned on, and controls the second switch module 140 to be turned off.

S1103: Configure the GPIO 3 with a high level, and configure the GPIO 4 with a low level.

A first power supply module 110 starts to work based on the high level at the GPIO 3, to supply power to a first I2C device 150 including a first serial data line interface SCL 1 and a first serial clock line interface SDA 1, thereby ensuring normal working of the first serial data line interface SCL 1 and the first serial clock line interface SDA 1. The second power supply module 130 does not work based on the low level at the GPIO 4.

S1104: Perform I2C signal interaction with the first I2C device 150.

When the SOC 90 controls the first switch module 120 to be turned on, and enables the first power supply module 110 through the GPIO 3 interface, the first power supply module 110 supplies power to the first serial data line interface SCL 1 and the first serial clock line interface SDA 1 through the first switch module 120 and a first pull-up resistor R1, and the first serial data line interface SCL 1 and the first serial clock line interface SDA 1 work normally. In this case, because the second switch module 140 is not turned on, and a second serial data line interface SCL 2 and a second serial clock line interface SDA 2 do not work, the SOC 90 may be electrically connected to the first serial data line interface SCL 1 through a third serial data line interface SCL 3, a first pin of a first connector 81, a first wire 83a, and a first pin of a second connector 82, and may be electrically connected to the first serial clock line interface SDA 1 through a third serial clock line interface SDA 3, a second pin of the first connector 81, a second wire 83b, and a second pin of the second connector 82, so that the SOC 90 implement I2C signal interaction with the first I2C device 150.

S1105: Control the first switch module 120 to be turned off, and the second switch module 140 to be turned on.

The SOC 90 controls the first switch module 120 to be turned off, and controls the second switch module 140 to be turned on.

S1106: Continue to configure the GPIO 3 with the high level, and continue to configure the GPIO 4 with a high level.

The first power supply module 110 starts to work based on the high level at the GPIO 3, to supply power to a power supply unit 92, to ensure normal working of interfaces of the SOC 90. The second power supply module 130 starts to work based on the high level at the GPIO 4, to supply power to the second serial data line interface SCL 2 and the second serial clock line interface SDA 2, thereby ensuring normal working of the second serial data line interface SCL 2 and the second serial clock line interface SDA 2.

S1107: Perform I2C signal interaction with a second I2C device 160.

When the SOC 90 controls the second switch module 140 to be turned on, and enables the second power supply module 130 through the GPIO 4 interface, the second power supply module 130 supplies power to the second serial data line interface SCL 2 and the second serial clock line interface SDA 2 through the second switch module 140 and a second pull-up resistor R2, and the second serial data line interface SCL 2 and the second serial clock line interface SDA 2 work normally. In this case, because the first switch module 120 is not turned on, and the first serial data line interface SCL 1 and the first serial clock line interface SDA 1 do not work, the SOC 90 may be electrically connected to the second serial data line interface SCL 2 through the third serial data line interface SCL 3, the first pin of the first connector 81, the first wire 83a, and the first pin of the second connector 82, and may be electrically connected to the second serial clock line interface SDA 2 through the third serial clock line interface SDA 3, the second pin of the first connector 81, the second wire 83b, and the second pin of the second connector 82, so that the SOC 90 and the second I2C device 160 implement I2C signal interaction.

It is to be noted that, the electronic device is also applicable to the foregoing solutions when the electronic device is the straight type terminal.

It is to be understood that, because the straight type terminal is not provided with two bodies, a rotating shaft structure, and two display units, recognizing IDs of the two display units may be recognizing IDs of at least two functional modules, and the functional modules may be, for example, devices such as a front-facing camera and a rear-facing camera on which ID recognition needs to be performed. The through-shaft FPC may be an FPC connecting a main board (that is, a first PCB 50) and a sub board (that is, a second PCB 60).

This embodiment further provides a computer storage medium. The computer storage medium stores computer instructions. When the computer instructions run on an electronic device, the electronic device is enabled to perform steps of the foregoing relevant methods to implement the signal transmission control method in the foregoing embodiments.

This embodiment further provides a computer program product. When the computer program product runs on a computer, the computer is caused to perform the related steps, to implement the signal transmission control method in the foregoing embodiments.

In addition, an embodiment of this application further provides an apparatus. The apparatus may be specifically a chip, a component, or a module. The apparatus may include a processor and a memory that are connected. The memory is configured to store computer-executable instructions. When the apparatus runs, the processor may execute the computer-executable instructions stored in the memory, to enable the chip to perform the signal transmission control method in the foregoing method embodiments.

The electronic device, the computer storage medium, the computer program product, or the chip provided in embodiments of this application may be configured to perform the corresponding method provided above. Therefore, for beneficial effects that can be achieved, refer to the beneficial effects of the corresponding method provided above. Details are not described herein again.

Based on the foregoing descriptions of the implementations, a person skilled in the art may understand that, for the purpose of convenient and brief description, division of the foregoing functional modules is merely used as an example for illustration. During actual application, the foregoing functions can be allocated to different functional modules for implementation according to a requirement, that is, an inner structure of an apparatus is divided into different functional modules to implement all or some of the functions described above.

In the several embodiments provided in this application, it is to be understood that the disclosed apparatus and method may be implemented in other manners. For example, the described apparatus embodiment is merely an example. For example, the module or unit division is merely logical function division and may be other division in actual implementation. For example, a plurality of units or components may be combined or integrated into another apparatus, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or another form.

## Claims

1. An electronic device, comprising:
a first printed circuit board (50) and a second printed circuit board (60);
a flexible printed circuit (70), a first connector (81), and a second connector (82), wherein one end of the flexible printed circuit is electrically connected to the first printed circuit board through the first connector, the other end of the flexible printed circuit is electrically connected to the second printed circuit board through the second connector, and the first connector and the second connector each comprise a first pin unit, a second pin unit, and a third pin unit;
a control module, arranged on the first printed circuit board;
at least two functional modules, arranged on the second printed circuit board, wherein the at least two functional modules comprise a first functional module and a second functional module, and both the first functional module and the second functional module are electrically connected to the control module through the first pin unit of the second connector, the flexible printed circuit, and the first pin unit of the first connector;
a first power supply module (110), electrically connected to the first functional module through the second pin unit, and configured to supply power to the first functional module;
a second power supply module (130), electrically connected to the second functional module through the third pin unit, and configured to supply power to the second functional module;
a first switch module (120), located between the first power supply module and the first functional module; and
a second switch module (140), located between the second power supply module and the second functional module, wherein
when the first switch module is turned on, the control module is configured to implement signal interaction with the first functional module, and when the second switch module is turned on, the control module is configured to implement signal interaction with the second functional module.

2. The electronic device according to claim 1, wherein the electronic device comprises a foldable terminal (100), wherein the foldable terminal comprises a first body (20), a second body (30), and a rotating shaft structure (40) connecting the first body and the second body;
the first printed circuit board is arranged in the first body, and the second printed circuit board is arranged in the second body; and
one end of the flexible printed circuit is electrically connected to the first printed circuit board through the first connector, and the other end of the flexible printed circuit passes through the rotating shaft structure and is electrically connected to the second printed circuit board through the second connector.

3. The electronic device according to claim 1 or 2, wherein the control module comprises a power supply unit (92) and an interface unit (91), wherein the power supply unit is respectively electrically connected to the first power supply module and the interface unit; and
the power supply unit is configured to supply power to the interface unit based on a power supply signal provided by the first power supply module, to enable the control module to implement signal interaction with the first functional module or the second functional module through the interface unit.

4. The electronic device according to claim 3, wherein the electronic device further comprises an isolation module (170), wherein one end of the isolation module, the first power supply module, and the first switch module are coupled to a first node (N1), and the other end of the isolation module, the second power supply module, and the second switch module are coupled to a second node (N2); and
when both the first switch module and the second switch module are turned on, the isolation module is configured to block a signal at the first node from being transmitted to the second node, and block a signal at the second node from being transmitted to the first node.

5. The electronic device according to claim 4, wherein the isolation module comprises a first diode (D1) and a second diode (D2); and
an anode of the first diode is connected to the first node, a cathode of the first diode is electrically connected to a cathode of the second diode, and an anode of the second diode is electrically connected to the second node.

6. The electronic device according to claim 3, wherein the control module comprises a system on chip; and
when the first switch module is turned on, the control module is configured to recognize an identity of the first functional module through the interface unit, and when the second switch module is turned on, the control module is configured to recognize an identity of the second functional module through the interface unit.

7. The electronic device according to claim 6, wherein when the electronic device comprises the foldable terminal, the first functional module comprises an inner screen, and the second functional module comprises an outer screen; and
when the first switch module is turned on, the control module is configured to recognize an identity of the inner screen through the interface unit, and when the second switch module is turned on, the control module is configured to recognize an identity of the outer screen through the interface unit.

8. The electronic device according to claim 3, wherein the control module comprises a system on chip, the first functional module comprises a first I2C device, and the second functional module comprises a second I2C device;
the first I2C device comprises a first serial data line interface and a first serial clock line interface, the second I2C device comprises a second serial data line interface and a second serial clock line interface, and the interface unit comprises a third serial data line interface and a third serial clock line interface;
both the second serial data line interface and the third serial data line interface are electrically connected to the first serial data line interface, and both the second serial clock line interface and the third serial clock line interface are electrically connected to the first serial clock line interface;
first pull-up resistors are respectively arranged between the first switch module and the first serial data line interface, and between the first switch module and the first serial clock line interface, and second pull-up resistors are respectively arranged between the second switch module and the second serial data line interface, and between the second switch module and the second serial clock line interface; and
when the first switch module is turned on, the control module is configured to implement I2C signal interaction with the first I2C device; and when the second switch module is turned on, the control module is configured to implement I2C signal interaction with the second I2C device.

9. The electronic device according to claim 1, wherein the first switch module comprises a metal-oxide-semiconductor transistor or a triode; and the second switch module comprises a metal-oxide-semiconductor transistor or a triode.

10. A signal transmission control method, applied to the electronic device according to any one of claims 1 to 9, and the signal transmission control method comprising:
controlling a first switch module to be turned on, to enable the first switch module to supply power to a first functional module;
performing signal interaction with the first functional module;
controlling the first switch module to be turned off, and controlling a second switch module to be turned on, to enable the second switch module to supply power to a second functional module; and
performing signal interaction with the second functional module.

11. The signal transmission control method according to claim 10, wherein the controlling a first switch module to be turned on, to enable the first switch module to supply power to a first functional module comprises:
controlling the first switch module to be turned on; and
sending a first control signal to the first functional module, to enable the first switch module to supply power to the first functional module; and
the controlling a second switch module to be turned on, to supply power to a second functional module comprises:
controlling the second switch module to be turned on; and
sending a second control signal to the second functional module, to enable the second switch module to supply power to the second functional module.

12. The signal transmission control method according to claim 11, wherein the performing signal interaction with the first functional module comprises:
obtaining an identification number of the first functional module; and
the performing signal interaction with the second functional module comprises:
obtaining an identification number of the second functional module.

13. The signal transmission control method according to claim 11, wherein the performing signal interaction with the first functional module comprises:
performing I2C signal interaction with the first functional module; and
the performing signal interaction with the second functional module comprises:
performing I2C signal interaction with the second functional module.

14. A computer-readable storage medium, comprising a computer program, wherein the computer program, when run on an electronic device, enables the electronic device to perform the signal transmission control method according to any one of claims 10 to 13.

## Patentansprüche

1. Elektronisches Gerät, umfassend:
eine erste Leiterplatte (50) und eine zweite Leiterplatte (60);
eine flexible Leiterplatte (70), einen ersten Steckverbinder (81) und einen zweiten Steckverbinder (82), wobei ein Ende der flexiblen Leiterplatte über den ersten Steckverbinder elektrisch mit der ersten Leiterplatte verbunden ist, das andere Ende der flexiblen Leiterplatte über den zweiten Steckverbinder elektrisch mit der zweiten Leiterplatte verbunden ist, und der erste Steckverbinder sowie der zweite Steckverbinder jeweils eine erste Pin-Einheit, eine zweite Pin-Einheit und eine dritte Pin-Einheit umfassen;
ein Steuermodul, das auf der ersten Leiterplatte angeordnet ist;
mindestens zwei Funktionsmodule, die auf der zweiten Leiterplatte angeordnet sind, wobei die mindestens zwei Funktionsmodule ein erstes Funktionsmodul und ein zweites Funktionsmodul umfassen, und sowohl das erste Funktionsmodul als auch das zweite Funktionsmodul über die erste Pin-Einheit des zweiten Steckverbinders, die flexible Leiterplatte und die erste Pin-Einheit des ersten Steckverbinders elektrisch mit dem Steuermodul verbunden sind;
ein erstes Stromversorgungsmodul (110), das über die zweite Pin-Einheit elektrisch mit dem ersten Funktionsmodul verbunden und dazu konfiguriert ist, das erste Funktionsmodul mit Strom zu versorgen;
ein zweites Stromversorgungsmodul (130), das über die dritte Pin-Einheit elektrisch mit dem zweiten Funktionsmodul verbunden und dazu konfiguriert ist, das zweite Funktionsmodul mit Strom zu versorgen;
ein erstes Schaltmodul (120), das zwischen dem ersten Stromversorgungsmodul und dem ersten Funktionsmodul angeordnet ist; und
ein zweites Schaltmodul (140), das zwischen dem zweiten Stromversorgungsmodul und dem zweiten Funktionsmodul angeordnet ist, wobei
wenn das erste Schaltmodul eingeschaltet ist, das Steuermodul dazu konfiguriert ist, eine Signalinteraktion mit dem ersten Funktionsmodul zu implementieren, und wenn das zweite Schaltmodul eingeschaltet ist, das Steuermodul dazu konfiguriert ist, eine Signalinteraktion mit dem zweiten Funktionsmodul zu implementieren.

2. Elektronisches Gerät nach Anspruch 1, wobei das elektronische Gerät ein faltbares Endgerät (100) umfasst, wobei das faltbare Endgerät einen ersten Körper (20), einen zweiten Körper (30) und eine Drehachsenstruktur (40) umfasst, die den ersten Körper und den zweiten Körper verbindet;
die erste Leiterplatte im ersten Körper angeordnet ist und die zweite Leiterplatte im zweiten Körper angeordnet ist; und
Ein Ende der flexiblen Leiterplatte ist über den ersten Steckverbinder elektrisch mit der ersten Leiterplatte verbunden, und das andere Ende der flexiblen Leiterplatte verläuft durch die Drehwellenstruktur und ist über den zweiten Steckverbinder elektrisch mit der zweiten Leiterplatte verbunden.

3. Elektronische Vorrichtung nach Anspruch 1 oder 2, wobei das Steuermodul eine Stromversorgungseinheit (92) und eine Schnittstelleneinheit (91) umfasst, wobei die Stromversorgungseinheit jeweils elektrisch mit dem ersten Stromversorgungsmodul und der Schnittstelleneinheit verbunden ist; und
die Stromversorgungseinheit dazu konfiguriert ist, die Schnittstelleneinheit basierend auf einem vom ersten Stromversorgungsmodul bereitgestellten Stromversorgungssignal mit Strom zu versorgen, um dem Steuermodul zu ermöglichen, eine Signalinteraktion mit dem ersten Funktionsmodul oder dem zweiten Funktionsmodul über die Schnittstelleneinheit zu implementieren.

4. Elektronische Vorrichtung nach Anspruch 3, wobei die elektronische Vorrichtung ferner ein Isolationsmodul (170) umfasst, wobei ein Ende des Isolationsmoduls, das erste Stromversorgungsmodul und das erste Schaltmodul an einen ersten Knoten (N1) gekoppelt sind und das andere Ende des Isolationsmoduls, das zweite Stromversorgungsmodul und das zweite Schaltmodul an einen zweiten Knoten (N2) gekoppelt sind; und
wenn sowohl das erste Schaltmodul als auch das zweite Schaltmodul eingeschaltet sind, das Isolationsmodul dazu konfiguriert ist, ein Signal am ersten Knoten daran zu hindern, an den zweiten Knoten übertragen zu werden, und ein Signal am zweiten Knoten daran zu hindern, an den ersten Knoten übertragen zu werden.

5. Elektronische Vorrichtung nach Anspruch 4, wobei das Isolationsmodul eine erste Diode (D1) und eine zweite Diode (D2) umfasst; und
eine Anode der ersten Diode mit dem ersten Knoten verbunden ist, eine Kathode der ersten Diode elektrisch mit einer Kathode der zweiten Diode verbunden ist und eine Anode der zweiten Diode elektrisch mit dem zweiten Knoten verbunden ist.

6. Elektronische Vorrichtung nach Anspruch 3, wobei das Steuermodul ein System-on-Chip umfasst; und
wenn das erste Schaltmodul eingeschaltet ist, das Steuermodul dazu konfiguriert ist, eine Identität des ersten Funktionsmoduls über die Schnittstelleneinheit zu erkennen, und wenn das zweite Schaltmodul eingeschaltet ist, das Steuermodul dazu konfiguriert ist, eine Identität des zweiten Funktionsmoduls über die Schnittstelleneinheit zu erkennen.

7. Elektronische Vorrichtung nach Anspruch 6, wobei, wenn die elektronische Vorrichtung das faltbare Endgerät umfasst, das erste Funktionsmodul einen inneren Bildschirm umfasst und das zweite Funktionsmodul einen äußeren Bildschirm umfasst; und
Wenn das erste Schaltmodul eingeschaltet ist, ist das Steuermodul so konfiguriert, dass es eine Identität des inneren Bildschirms über die Schnittstelleneinheit erkennt, und wenn das zweite Schaltmodul eingeschaltet ist, ist das Steuermodul so konfiguriert, dass es eine Identität des äußeren Bildschirms über die Schnittstelleneinheit erkennt.

8. Elektronische Vorrichtung nach Anspruch 3, wobei das Steuermodul ein System-on-Chip umfasst, das erste Funktionsmodul ein erstes I2C-Gerät umfasst und das zweite Funktionsmodul ein zweites I2C-Gerät umfasst;
wobei das erste I2C-Gerät eine erste serielle Dateneitungsschnittstelle und eine erste serielle Takteleitungsschnittstelle umfasst, das zweite I2C-Gerät eine zweite serielle Dateneitungsschnittstelle und eine zweite serielle Takteleitungsschnittstelle umfasst und die Schnittstelleneinheit eine dritte serielle Dateneitungsschnittstelle und eine dritte serielle Takteleitungsschnittstelle umfasst;
wobei sowohl die zweite serielle Dateneitungsschnittstelle als auch die dritte serielle Dateneitungsschnittstelle elektrisch mit der ersten seriellen Dateneitungsschnittstelle verbunden sind, und sowohl die zweite serielle Takteleitungsschnittstelle als auch die dritte serielle Takteleitungsschnittstelle elektrisch mit der ersten seriellen Takteleitungsschnittstelle verbunden sind;
wobei erste Pull-up-Widerstände jeweils zwischen dem ersten Schaltmodul und der ersten seriellen Dateneitungsschnittstelle sowie zwischen dem ersten Schaltmodul und der ersten seriellen Takteleitungsschnittstelle angeordnet sind, und zweite Pull-up-Widerstände jeweils zwischen dem zweiten Schaltmodul und der zweiten seriellen Dateneitungsschnittstelle sowie zwischen dem zweiten Schaltmodul und der zweiten seriellen Takteleitungsschnittstelle angeordnet sind; und
wenn das erste Schaltmodul eingeschaltet ist, ist das Steuermodul so konfiguriert, dass es eine I2C-Signalinteraktion mit dem ersten I2C-Gerät implementiert; und wenn das zweite Schaltmodul eingeschaltet ist, ist das Steuermodul so konfiguriert, dass es eine I2C-Signalinteraktion mit dem zweiten I2C-Gerät implementiert.

9. Elektronische Vorrichtung nach Anspruch 1, wobei das erste Schaltmodul einen Metall-Oxid-Halbleiter-Transistor oder eine Triode umfasst; und das zweite Schaltmodul einen Metall-Oxid-Halbleiter-Transistor oder eine Triode umfasst.

10. Signalübertragungssteuerungsverfahren, angewendet auf die elektronische Vorrichtung nach einem der Ansprüche 1 bis 9, wobei das Signalübertragungssteuerungsverfahren umfasst:
Steuern eines ersten Schaltmoduls, damit dieses eingeschaltet wird, um dem ersten Schaltmodul die Stromversorgung eines ersten Funktionsmoduls zu ermöglichen;
Durchführen einer Signalinteraktion mit dem ersten Funktionsmodul;
Steuern des ersten Schaltmoduls, damit dieses ausgeschaltet wird, und Steuern eines zweiten Schaltmoduls, damit dieses eingeschaltet wird, um dem zweiten Schaltmodul die Stromversorgung eines zweiten Funktionsmoduls zu ermöglichen; und
Durchführen einer Signalinteraktion mit dem zweiten Funktionsmodul.

11. Verfahren zur Signalübertragungssteuerung nach Anspruch 10, wobei das Steuern eines ersten Schaltmoduls, sodass dieses eingeschaltet wird, um das erste Schaltmodul in die Lage zu versetzen, ein erstes Funktionsmodul mit Strom zu versorgen, Folgendes umfasst:
Steuern des ersten Schaltmoduls, sodass dieses eingeschaltet wird; und
Senden eines ersten Steuersignals an das erste Funktionsmodul, um das erste Schaltmodul in die Lage zu versetzen, das erste Funktionsmodul mit Strom zu versorgen; und
das Steuern eines zweiten Schaltmoduls, sodass dieses eingeschaltet wird, um ein zweites Funktionsmodul mit Strom zu versorgen, umfasst:
Steuern des zweiten Schaltmoduls, sodass dieses eingeschaltet wird; und
Senden eines zweiten Steuersignals an das zweite Funktionsmodul, um das zweite Schaltmodul in die Lage zu versetzen, das zweite Funktionsmodul mit Strom zu versorgen.

12. Verfahren zur Signalübertragungssteuerung nach Anspruch 11, wobei das Durchführen einer Signalinteraktion mit dem ersten Funktionsmodul Folgendes umfasst:
Erhalten einer Identifikationsnummer des ersten Funktionsmoduls; und
das Durchführen einer Signalinteraktion mit dem zweiten Funktionsmodul Folgendes umfasst:
Erhalten einer Identifikationsnummer des zweiten Funktionsmoduls.

13. Verfahren zur Signalübertragungssteuerung nach Anspruch 11, wobei das Durchführen einer Signalinteraktion mit dem ersten Funktionsmodul Folgendes umfasst:
Durchführen einer I2C-Signalinteraktion mit dem ersten Funktionsmodul; und
das Durchführen einer Signalinteraktion mit dem zweiten Funktionsmodul Folgendes umfasst:
Durchführen einer I2C-Signalinteraktion mit dem zweiten Funktionsmodul.

14. Computerlesbares Speichermedium, das ein Computerprogramm umfasst, wobei das Computerprogramm, wenn es auf einer elektronischen Vorrichtung ausgeführt wird, die elektronische Vorrichtung dazu befähigt, das Verfahren zur Signalübertragungssteuerung nach einem der Ansprüche 10 bis 13 durchzuführen.

## Revendications

1. Dispositif électronique, comprenant :
une première carte de circuit imprimé (50) et une seconde carte de circuit imprimé (60) ;
un circuit imprimé flexible (70), un premier connecteur (81) et un second connecteur (82), dans lequel une extrémité du circuit imprimé flexible est connectée électriquement à la première carte de circuit imprimé par l'intermédiaire du premier connecteur, l'autre extrémité du circuit imprimé flexible est connectée électriquement à la seconde carte de circuit imprimé par l'intermédiaire du second connecteur, et le premier connecteur ainsi que le second connecteur comprennent chacun une première unité de broches, une deuxième unité de broches et une troisième unité de broches ;
un module de commande, disposé sur la première carte de circuit imprimé ;
au moins deux modules fonctionnels, disposés sur la seconde carte de circuit imprimé, dans lequel les au moins deux modules fonctionnels comprennent un premier module fonctionnel et un second module fonctionnel, et le premier module fonctionnel ainsi que le second module fonctionnel sont tous deux connectés électriquement au module de commande par l'intermédiaire de la première unité de broches du second connecteur, du circuit imprimé flexible et de la première unité de broches du premier connecteur ;
un premier module d'alimentation (110), connecté électriquement au premier module fonctionnel par l'intermédiaire de la deuxième unité de broches, et configuré pour alimenter le premier module fonctionnel ;
un second module d'alimentation (130), connecté électriquement au second module fonctionnel par l'intermédiaire de la troisième unité de broches, et configuré pour alimenter le second module fonctionnel ;
un premier module de commutation (120), situé entre le premier module d'alimentation et le premier module fonctionnel ; et
un second module de commutation (140), situé entre le second module d'alimentation et le second module fonctionnel, dans lequel
lorsque le premier module de commutation est activé, le module de commande est configuré pour mettre en œuvre une interaction de signal avec le premier module fonctionnel, et lorsque le second module de commutation est activé, le module de commande est configuré pour mettre en œuvre une interaction de signal avec le second module fonctionnel.

2. Dispositif électronique selon la revendication 1, dans lequel le dispositif électronique comprend un terminal pliable (100), dans lequel le terminal pliable comprend un premier corps (20), un second corps (30) et une structure d'axe de rotation (40) reliant le premier corps et le second corps ;
la première carte de circuit imprimé est disposée dans le premier corps, et la seconde carte de circuit imprimé est disposée dans le second corps ; et
une extrémité du circuit imprimé flexible est connectée électriquement à la première carte de circuit imprimé par l'intermédiaire du premier connecteur, et l'autre extrémité du circuit imprimé flexible passe à travers la structure d'arbre rotatif et est connectée électriquement à la seconde carte de circuit imprimé par l'intermédiaire du second connecteur.

3. Dispositif électronique selon la revendication 1 ou 2, dans lequel le module de commande comprend une unité d'alimentation (92) et une unité d'interface (91), dans lequel l'unité d'alimentation est connectée électriquement respectivement au premier module d'alimentation et à l'unité d'interface ; et
l'unité d'alimentation est configurée pour fournir de l'énergie à l'unité d'interface sur la base d'un signal d'alimentation fourni par le premier module d'alimentation, pour permettre au module de commande de mettre en œuvre une interaction de signal avec le premier module fonctionnel ou le second module fonctionnel par l'intermédiaire de l'unité d'interface.

4. Dispositif électronique selon la revendication 3, dans lequel le dispositif électronique comprend en outre un module d'isolation (170), dans lequel une extrémité du module d'isolation, le premier module d'alimentation et le premier module de commutation sont couplés à un premier nœud (N1), et l'autre extrémité du module d'isolation, le second module d'alimentation et le second module de commutation sont couplés à un second nœud (N2) ; et
lorsque le premier module de commutation et le second module de commutation sont tous deux activés, le module d'isolation est configuré pour bloquer la transmission d'un signal au niveau du premier nœud vers le second nœud, et pour bloquer la transmission d'un signal au niveau du second nœud vers le premier nœud.

5. Dispositif électronique selon la revendication 4, dans lequel le module d'isolation comprend une première diode (D1) et une seconde diode (D2) ; et
une anode de la première diode est connectée au premier nœud, une cathode de la première diode est connectée électriquement à une cathode de la seconde diode, et une anode de la seconde diode est connectée électriquement au second nœud.

6. Dispositif électronique selon la revendication 3, dans lequel le module de commande comprend un système sur puce (system on chip) ; et
lorsque le premier module de commutation est activé, le module de commande est configuré pour reconnaître une identité du premier module fonctionnel par l'intermédiaire de l'unité d'interface, et lorsque le second module de commutation est activé, le module de commande est configuré pour reconnaître une identité du second module fonctionnel par l'intermédiaire de l'unité d'interface.

7. Dispositif électronique selon la revendication 6, dans lequel lorsque le dispositif électronique comprend le terminal pliable, le premier module fonctionnel comprend un écran interne, et le second module fonctionnel comprend un écran externe ; et
lorsque le premier module de commutation est activé, le module de commande est configuré pour reconnaître une identité de l'écran intérieur par l'intermédiaire de l'unité d'interface, et lorsque le second module de commutation est activé, le module de commande est configuré pour reconnaître une identité de l'écran extérieur par l'intermédiaire de l'unité d'interface.

8. Le dispositif électronique selon la revendication 3, dans lequel le module de commande comprend un système sur puce, le premier module fonctionnel comprend un premier dispositif I2C, et le second module fonctionnel comprend un second dispositif I2C ;
le premier dispositif I2C comprend une première interface de ligne de données série et une première interface de ligne d'horloge série, le second dispositif I2C comprend une seconde interface de ligne de données série et une seconde interface de ligne d'horloge série, et l'unité d'interface comprend une troisième interface de ligne de données série et une troisième interface de ligne d'horloge série ;
la seconde interface de ligne de données série et la troisième interface de ligne de données série sont toutes deux connectées électriquement à la première interface de ligne de données série, et la seconde interface de ligne d'horloge série et la troisième interface de ligne d'horloge série sont toutes deux connectées électriquement à la première interface de ligne d'horloge série ;
des premières résistances de tirage sont respectivement disposées entre le premier module de commutation et la première interface de ligne de données série, et entre le premier module de commutation et la première interface de ligne d'horloge série, et des secondes résistances de tirage sont respectivement disposées entre le second module de commutation et la seconde interface de ligne de données série, et entre le second module de commutation et la seconde interface de ligne d'horloge série ; et
lorsque le premier module de commutation est activé, le module de commande est configuré pour mettre en œuvre une interaction de signal I2C avec le premier dispositif I2C ; et lorsque le second module de commutation est activé, le module de commande est configuré pour mettre en œuvre une interaction de signal I2C avec le second dispositif I2C.

9. Le dispositif électronique selon la revendication 1, dans lequel le premier module de commutation comprend un transistor métal-oxyde-semiconducteur ou un triode ; et le second module de commutation comprend un transistor métal-oxyde-semiconducteur ou un triode.

10. Procédé de commande de transmission de signal, appliqué au dispositif électronique selon l'une quelconque des revendications 1 à 9, et le procédé de commande de transmission de signal comprenant :
commander l'activation d'un premier module de commutation, pour permettre au premier module de commutation de fournir de l'énergie à un premier module fonctionnel ;
effectuer une interaction de signal avec le premier module fonctionnel ;
commander la désactivation du premier module de commutation, et commander l'activation d'un second module de commutation, pour permettre au second module de commutation de fournir de l'énergie à un second module fonctionnel ; et
effectuer une interaction de signal avec le second module fonctionnel.

11. Procédé de commande de transmission de signal selon la revendication 10, dans lequel la commande d'un premier module de commutation pour être mis sous tension, afin de permettre au premier module de commutation d'alimenter un premier module fonctionnel, comprend :
la commande du premier module de commutation pour être mis sous tension ; et
l'envoi d'un premier signal de commande au premier module fonctionnel, pour permettre au premier module de commutation d'alimenter le premier module fonctionnel ; et
la commande d'un second module de commutation pour être mis sous tension, afin d'alimenter un second module fonctionnel, comprend :
la commande du second module de commutation pour être mis sous tension ; et
l'envoi d'un second signal de commande au second module fonctionnel, pour permettre au second module de commutation d'alimenter le second module fonctionnel.

12. Procédé de commande de transmission de signal selon la revendication 11, dans lequel l'exécution d'une interaction de signal avec le premier module fonctionnel comprend :
l'obtention d'un numéro d'identification du premier module fonctionnel ; et
l'exécution d'une interaction de signal avec le second module fonctionnel comprend :
l'obtention d'un numéro d'identification du second module fonctionnel.

13. Procédé de commande de transmission de signal selon la revendication 11, dans lequel l'exécution d'une interaction de signal avec le premier module fonctionnel comprend :
l'exécution d'une interaction de signal I2C avec le premier module fonctionnel ; et
l'exécution d'une interaction de signal avec le second module fonctionnel comprend :
l'exécution d'une interaction de signal I2C avec le second module fonctionnel.

14. Support de stockage lisible par ordinateur, comprenant un programme informatique, dans lequel le programme informatique, lorsqu'il est exécuté sur un dispositif électronique, permet au dispositif électronique d'exécuter le procédé de commande de transmission de signal selon l'une quelconque des revendications 10 à 13.
